# EUROPEAN PATENT SPECIFICATION

(11) **EP 4 450 989 B1**
(45) Date of publication and mention of the grant of the patent: **23.09.2026**
(21) Application number: 23275067.9
(22) Date of filing: 21.04.2023
(51) Int. Cl.: G01R 31/42, G01R 31/64, G01R 31/40

(54) **HEALTH MONITORING OF INPUT FILTER FOR DEGRADATION DETECTION**
GESUNDHEITSÜBERWACHUNG EINES EINGANGSFILTERS ZUR DEGRADATIONSERKENNUNG
SURVEILLANCE DE L'ÉTAT D'UN FILTRE D'ENTRÉE POUR LA DÉTECTION DE DÉGRADATION

(43) Date of publication of application: 23.10.2024
(73) Proprietor: Hamilton Sundstrand Corporation, Charlotte, NC 28217 (US)
(72) Inventor: AL-KARAGHOULI, Ali, Solihull, B90 4XL (GB); MANN, Jaspreet Kaur, Birmingham, B90 1JQ (GB)
(74) Representative: Dehns

(56) References cited:
- US-A1- 2017 149 343

## Description

### FIELD

This invention relates to health monitoring of an input filter network within a power system for detecting degradation of at least one component of the input filter network.

### BACKGROUND

Power districts form a part of aircraft's power distribution. Each power district can consist of a power rack with multiple AC fed inverters, of which outputs can be multiplexed and/or paralleled by a switching matrix to drive various loads (e.g. electric motors).

Motor drive electronics in an aircraft must comply with industry standard Electromagnetic Interference (EMI) requirements for use in an aircraft. Owing to the electrification of aircraft systems, and the use of fast switching power semiconductor devices in motor drive electronics, there exist strict requirements on the reliability of EMI filters that form an important circuit of a 3-phase AC input.

An EMI input filter network has two main functions. Firstly, the input filter network must suppress noise emitted from motor drive electronics so that it does not adversely affect other systems on the same electrical grid. Secondly, the filter must supress unwanted noise from aircraft's power grid that could affect the control of electrical motors. These functions are critical to maintain reliable motor control throughout the lifetime of an aircraft, which is typically 25 or more years.

Despite the fact that the input filter (like all aircraft systems) is designed to operate in challenging conditions, for example over a wide temperature range and under high levels of vibration; premature aging, or manufacturing issues may lead to component degradation. Degradation of of one component of an input filter network can affect the conducted emissions (i.e. passing through all signals, as opposed to the designed selective filtering) as well as the radiated emissions, thereby changing the susceptibility of the entire system and potentially leading to erroneous control of the motor or other subsystems on the same power grid.

Prior art document US2017/149343 discloses a motor drive for driving a three-phase motor, and comprising a three phase AC input filter. A degradation detection circuit senses currents and voltages of the filter to determine whether the filter or components thereof has degraded, using the AC mains input itself as a test signal.

In the existing motor drive electronics, neither built-in-tests nor online health monitoring capabilities are provided to understand component degradation or an impending failure of the input filter network.

Therefore, it would be desirable to monitor degradation of input filter components to prevent unscheduled maintenance and high costs due to unavailability of the system.

### SUMMARY

From a first aspect, there is provided a method according to claim 1.

Thus it will be seen that, in accordance with examples of the disclosure, a simple yet effective method for easily testing components of a motor drive in order to detect degradation may be achieved. Such testing may be repeated regularly to monitor the health a component in the power district, such as a part of a start-up or diagnostic routine. For example, the above method may be performed upon a regular start-up of an aircraft, in order to accurately track any potential performance degradation, and how it might be developing over time. This data may be used during a scheduled repair, or used to prompt the scheduling of a repair to fix the identified issues. Additionally, or alternatively, such a routine may be performed during maintenance in order to determine whether certain components in a motor drive, or within a motor should be serviced.

By monitoring component degradation, it is possible to proactively identify any potential failures before complete failure, and then a scheduled repair may planned be to address the source of the degradation. As such, there results in an improved reliability due to the capability of performing preventive maintenance and hence prognostics in motor drive systems.

The at least one component may comprise an input filter of the motor drive circuit. Prior to injecting a test signal to the input filter network of the isolated motor drive circuit, disconnecting the motor from the motor drive circuit, such that test signal is provided through only the input filter network of the motor drive circuit. In this way, issues specific to input filters may be tested. Should there be a change in the signal propagated through the filter when compared to a reference signal, a degradation may be identified.

The test signal may be a low voltage pulse width modulation, PWM, signal. Such a signal may be provided from low voltage DC power supplies that are already part of the motor drive circuit, or alternatively part of a dedicated signal generator. By providing a low voltage signal, the normal operation of the motor drive system may not be affected.

The comparison of propagated signal to a test signal may comprise comparing voltage levels of the propagated signal and the test signal at different timing intervals. This may provide a simple way to compare the two signals.

The method may further comprise generating the test signal by, upon installation of the power system, isolating the motor drive circuit from the power source; injecting the test signal to the input filter network of the isolated motor drive circuit; measuring a propagated signal resulting from the injected test signal propagating through the input filter network; and storing the propagated signal as the reference signal. In this way, the reference signal may be tailored so that it reflects the exact component that is installed in, and later to be tested in the motor drive circuit. Any deviation/failure in any of those components would then be reflected in a changed propagated signal.

The motor drive may be a first motor drive of a plurality of motor drives, and each of the plurality of motor drives may be connected to at least one of a plurality of motors via a reconfiguration matrix, and the reconfiguration matrix may connect a desired motor drive of the plurality of motor drives to the output of the first motor drive such that the degradation of at the input filter network of the desired motor drive may be monitored. In this way, a single motor drive that is configured to perform such testing may be used to not only test for degradation within its own circuitry (and one or more motors which it powers), but it may equally be able to test the degradation within of other motor drives that are provided in a multiplexed control system.

From a second aspect, there is provided a motor drive according to claim 7.

Such a motor drive may be able to carry out the above methods, such that it is provided with the ability to detect any degradation in one or more of its components, or equally degradation in any other motor drives/motors that may be connected thereto.

The motor drive may further comprise motor drive electronics comprising a rectifier, at least one DC link capacitor and an inverter, and the means for measuring a propagated signal may comprise a motor controller. The motor drive may be configured to test only the input filter, by isolating the input filter from a motor at its output using the motor drive electronics. Alternatively, such a motor drive may additionally test for degradation in the motor drive electronics and motor in addition to the input filter, by keeping all of these components in the testing circuit.

The means for injecting a test signal to the input filter network of the motor drive may comprise a dedicated signal generator. The motor drive may further comprise protection diodes configured to prevent power being fed to the means for injecting a test signal during normal use.

The means for injecting a test signal to the input filter network of the motor drive may be configured to provide a signal having 28V or less.

In a third aspect, there is provided a system comprising a power source configured to provide AC power; the motor drive as described above; and a motor. Such a system may be able to detect degradation within the motor drive, or the motor.

In a fourth aspect, there is provided a system comprising a plurality of motor drives, wherein at least one of the motor drives is a first motor drive, and is a motor drive as described above; a plurality of motors; and each of the plurality of motor drives is connected to at least one of the plurality of motors via a reconfiguration matrix.

The reconfiguration matrix may be further configured such that one of the plurality of motor drives may be connected to the output of the first motor drive, such that the first motor drive can monitor degradation of an input filter network of any of the plurality of motor drives.

### BRIEF DESCRIPTION OF THE DRAWINGS

Certain examples of the disclosure will now be described, by way of example only, with reference to the accompanying drawings, in which:
Figure 1 is a schematic diagram of a motor drive system;
Figure 2 is a schematic diagram of a power district, such as a power district of an aircraft.

### DETAILED DESCRIPTION

In order to address the above issues, the present invention provides a method, as well as a system that uses a simple signal generator, such as a low voltage Pulse Width Modulator (PWM) generator and an analogue to digital converter to monitor and detect impending failures in input filter network components. Such a detection may occur whilst the system is in use, and/or at regular intervals during the lifetime of the system. It would be understood that a "low voltage" test signal may refer to a signal that is of sufficiently low voltage such that it does not affect the normal operation of the motor drive system, such as 28V or less.

Whilst the examples described herein are described with reference to an aircraft's power district and motor drive system, as would be understood, the present invention may find use in other applications, and is not limited to its use within aircraft.

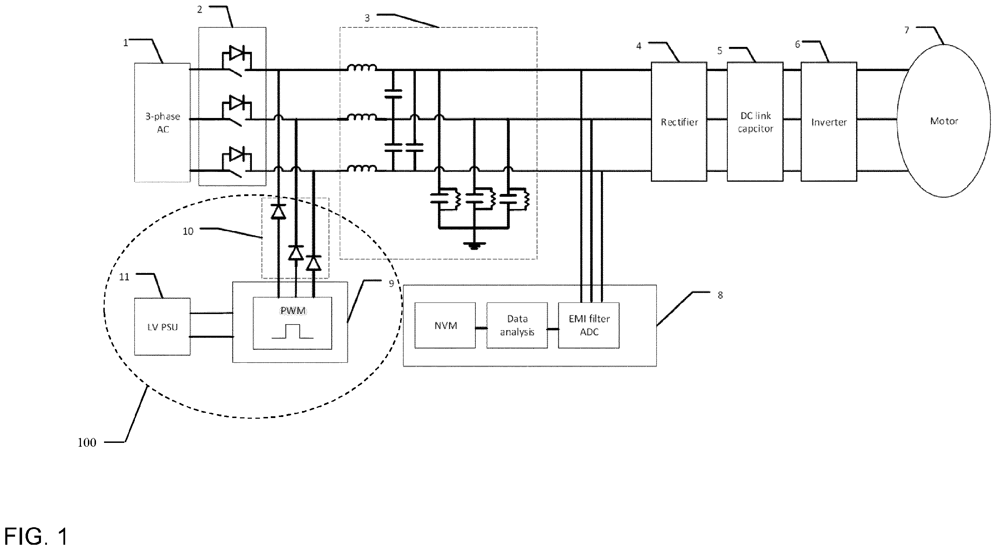

Figure 1 shows an example motor drive system capable of health monitoring of components of an input filter and hence degradation detection.

The system comprises a power source 1, means for isolating the power source from the remainder of the motor drive system such as switches/diodes 2, input filter 3, motor drive electronics comprising a rectifier stage 4, DC link capacitor(s) 5, and an inverter 6, and a motor 7 connected to the output of the motor drive electronics. The motor drive may further comprise a controller 8, for example a motor controller for providing control of motor 7.

As would be appreciated, the input filter network 3 may comprise multiple stages to filter and damp the noise at various frequencies using typical components, such as common mode choke/capacitors and differential mode chokes/capacitors. Should one or more of these components fail (for example, should one or more of the capacitors go open circuit), then it is possible that they would not filter their intended frequencies, but rather allow such frequencies to pass through the input filter network, and into the motor control (or vice versa, from the motor control to the power grid). Typically, should such a failure occur, it would be undetectable by the system, and the system would continue to operate in an unstable and non-compliant manner, potentially causing further failure. Even when an eventual failure is detected, it may prove difficult to identify the ultimate cause of the failure, without individually testing all potential failure modes.

Therefore the motor drive circuit may be provided with means for injecting a test signal 100 to the motor drive circuit to enable monitoring of the health of the input filter network.

For example, means for injecting a test signal 100 may comprise PWM controller 9, and protection diodes 10. The PWM controller 9 may be configured to provide a signal from a DC low voltage power supply 11 that may already form part of the motor drive system. The DC low voltage power supply unit 11 and PWM controller 9 may be configured to inject a low voltage PWM signal through protection diodes 10. The motor controller 8 may then be used to monitor a propagated signal, such as the resulting low voltage PWM signal after it goes through the input filter network 3 (and optionally, other connected loads). For example, the propagated signal may be processed by an FPGA or a microprocessor of the - motor controller 8. The protection diodes 10 may be provided such that, during normal use of the motor drive system, they are reverse biased so no power is fed to the PWM generator 9 and low voltage power supply 11.

As can be seen in Figure 1, the motor drive is provided with a means for isolating the power source 1 from the remainder of the motor drive system, thereby preventing the test signal from being transmitted back towards the power supply 1, and/or the rest of the associated power grid. For example, diodes and/or switches 2 may be provided on each phase of the input power so that the power supply 1 may be disconnected from the motor drive circuit during health monitoring.

Further, if desired, switches in the rectifier stage 4 and the inverter 6 of the motor control may be utilized to disconnect the motor 7 (and/or other associated loads) from the motor drive circuit. In this way, the circuit can be configured such that the test signal may propagate only through the input filter network, rather than out to the power grid and the attached loads. Advantageously, by utilizing the rectifier 4 and inverter 6 switches to isolate certain parts of the motor drive circuit for monitoring, they may be configured to selectively include the motor as part of the test circuit, thereby allowing the motor to be part of the monitor circuit or not, as desired.

As the generated test signal is injected through the attached components (whether that just be the input filter network 3, or also optionally other attached loads), the signal will change sign and/or magnitude depending on the impedance of the attached components. For a new filter network 3 (and optionally attached loads), when a known test signal 100 is injected through it, the propagated signal can be recorded and stored in a non-volatile memory, NVM, such as the NVM of the controller, and noted as a known propagated signal resulting from new, healthy components. The test may then be repeated as desired by injecting the same known signal, and the propagated signal compared to the (healthy) signal stored in the NVM.

For example, upon installation of the motor drive signal, a low voltage PWM test signal may be generated and injected through the input filter network 3, and optionally the motor, and the propagated signal stored in the NVM. If at a later date the test is performed again, and there has been any degradation or changes in the input filter network 3 (and the motor/other loads, if part of the testing circuit), then the shape of the propagated signal seen by the motor controller 8 changes, as compared to the stored healthy signal (i.e. the signal stored in the NVM). Following the identification of such a change, for example, a change in sign and/or magnitude, a degradation may be identified.

The recorded test signal seen by the motor controller 8 can be stored in the form of various parameters, such as the voltage levels at different timing intervals. Such parameters may then be used as a pass or fail criteria for all subsequent diagnostic checks throughout the life of the product.

In summary, in order to perform a diagnostic test on the circuit of Figure 1, the following diagnostic steps can be followed:
1. Isolate the desired components (for example, the components of the input filter network) from the rest of the system with the use of diodes/switches 2 and switches of the rectifier 4 and/or inverter 6 in the motor drive electronics. For example, just the input filter network 3 may be isolated from the rest of the circuit. Alternatively, the filter network may not be isolated from the motor.
2. Store a baseline waveform parameter by injecting the test signal and use the controller to measure the propagated signal as it injects through the attached loads. This should be done when the unit is powered on for the first time, or alternatively, when the test circuit is installed for the first time.
3. Perform a diagnostic check by repeating steps 1 and 2. This can be done every time the unit is powered on, or when programmed to do so. The measured parameters of new propagated signal can be compared with the baseline parameters captured in step 2.

As above, the tests may be performed at any time during the life of the motor controller. For example, the tests may be performed on startup of the motor drive. If there is a significant change between the initial measured test waveform and the new waveform, a warning may be reported to the controller and hence the entire system.

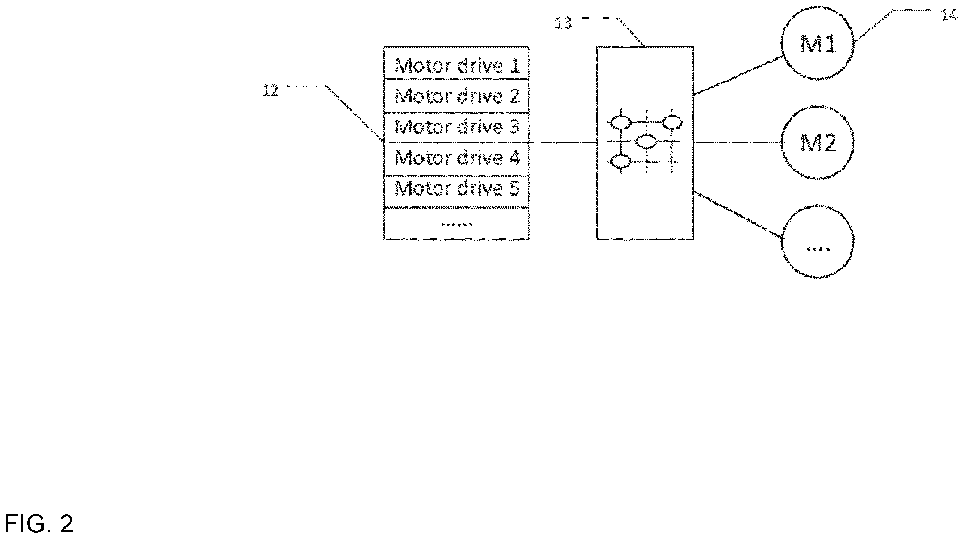

Figure 2 shows a power district architecture example where multiple motor drives 12 may be combined in parallel to drive one or more motors 14, depending on the system requirements. This is managed through a reconfiguration matrix 13 (for example, a multiplexer) to connect the required motor(s) 14 to the required motor drive(s) 12, thereby allowing each motor drive 12 to drive any one or more of the motors 14, M1, M2 etc. Such a power district may be found in, for example, an aircraft.

The input filter network monitoring method set out above may still be used in this setup, and a single motor drive can test all the connected motors. For example, motor drive 1 can have the circuit configuration shown in Figure 1. Following the above steps above, the method can be used to monitor the input filter network of the remaining motor drives, with only a single detection circuit. In this way, whilst the reconfiguration matrix 13 may be is used to multiplex loads (i.e. motors) during normal operation, it may be used to test other input filter networks within the system. For example, the input filter monitoring motor drive 1 (having a configuration as shown in Figure 1) can be used as a "degradation tester" and connect to the outputs of motor drive 2 via the reconfiguration matrix 13. The connection of another motor drive to the outputs of motor drive 1 allows for the performance of motor drive 2 (or any motor load within the system) to be checked (and by proxy, the input filters of that motor drive). As the performance of the input filter network of the first motor drive can be monitored in isolation, then it is possible to attribute any further performance degradation to the load that is connected by the multiplexer.

Such a method allows the system to monitor the health of the input filter network in the power district as a part of start-up or diagnostic routine. For example, the above method may be performed upon a regular start-up of an aircraft, to accurately monitor any potential performance degradation, and how it might develop over time. This data may be used during a scheduled repair, or used to prompt the scheduling of a repair to fix the identified issues. Additionally, or alternatively, such a routine may be performed during maintenance to determine whether certain components in an input filter network, require a service.

By monitoring component degradation of input filter networks, it is possible to proactively identify any potential failures before complete failure, then a scheduled repair may planned be to address the source of the degradation. This results in an improved reliability and the capability to perform preventive maintenance and hence prognostics in motor drive systems.

By effectively monitoring the health of the input filter and its connected loads, whether that be as part of aircraft start-up or diagnostic routine, it is possible to mitigate the issues outlined above by detecting degradation, and its exact source before it results in total failure. Therefore, by providing circuits and methods outlined herein allows not only prevents unscheduled maintenance in the wake of a total failure, but also directs maintenance towards the components that require servicing, rather than requiring a complete diagnostic investigation to find the source of a complete failure. Advantageously, this health monitoring capability may be provided using a largely unmodified circuit design in typical motor drive electronics.

## Claims

1. A method for monitoring degradation of at least one component of an input filter network in a power system comprising a motor drive circuit configured to provide AC power from a power source (1) to power a motor (7), the method comprising:
isolating the motor drive circuit from the power source (1);
injecting a test signal to the input filter network of the isolated motor drive circuit;
measuring a propagated signal resulting from the injected test signal propagating through the filter network;
comparing the propagated signal to a reference signal and, if the propagated signal differs from the reference signal by sign and/or magnitude, then identifying degradation of at least one component of the filter network.

2. The method of claim 1, further comprising, prior to injecting a test signal to the input filter network (3) of the isolated motor drive circuit, disconnecting the motor (7) from the motor drive circuit, such that test signal is provided through only the input filter network (3) of the motor drive circuit.

3. The method of any preceding claim, wherein the test signal is a low voltage pulse width modulation, PWM, signal.

4. The method of any preceding claim, wherein the comparing the propagated signal to a test signal comprises comparing voltage levels of the propagated signal and the test signal at different timing intervals.

5. The method of any preceding claim, further comprising generating the test signal by, upon installation of the power system,
isolating the motor drive circuit from the power source (1);
injecting the test signal to the input filter network (3) of the isolated motor drive circuit;
measuring a propagated signal resulting from the injected test signal propagating through the input filter network (3);
storing the propagated signal as the reference signal.

6. The method of any preceding claim, wherein the motor drive is a first motor drive of a plurality of motor drives, and each of the plurality of motor drives is connected at least one of a plurality of motors (14) via a reconfiguration matrix (13), and wherein the reconfiguration matrix connects a desired motor drive of the plurality of motor drives to the output of the first motor drive such that the degradation of the input filter network of the desired motor drive may be monitored.

7. A motor drive for performing the method of any preceding claim, the motor drive being configured to, in use, connect to an AC power source at its input and drive a motor (7) at its output, the motor drive comprising:
means (2) for isolating the motor drive from the AC power source;
at least one input filter network (3);
means (100) for injecting a test signal to the input filter network (3) of the isolated motor drive;
means (8) for measuring a propagated signal resulting from the injected test signal propagating through the input filter network (3); and
means for comparing the propagated signal to a reference signal such that, if the propagated signal differs from the reference signal by sign and/or magnitude, then degradation of at least one component of the input filter network (3) may be identified.

8. The motor drive of claim 7, wherein the motor drive further comprises motor drive electronics comprising a rectifier (4), at least one DC link capacitor (5) and an inverter (6), and wherein the means (8) for measuring a propagated signal comprises a motor controller (8).

9. The motor drive of claim 8, wherein the motor drive electronics are configured to isolate the motor drive from a motor (7) connected at its output.

10. The motor drive of any of claims 7 to 9, wherein the means (100) for injecting a test signal to the input filter network (3) of the motor drive comprises a dedicated signal generator.

11. The motor drive of any of claims 7 to 10, further comprising protection diodes (10) configured to prevent power being fed to the means (100) for injecting a test signal during normal use.

12. The motor drive of any of claims 7 to 11, wherein the means (100) for injecting a test signal to the input filter network (3) of the motor drive is configured to provide a signal having 28V or less.

13. A system comprising
a power source (1) configured to provide AC power;
the motor drive of any of claims 9 to 12 and
a motor (7).

14. A system comprising
a plurality of motor drives (12), wherein at least one of the motor drives is a first motor drive, and is a motor drive as claimed in any of claims 9 to 12;
a plurality of motors (14);
wherein each of the plurality of motor drives is connected at least one of the plurality of motors (14) via a reconfiguration matrix (13).

15. The system of claim 14, wherein the reconfiguration matrix (13) is further configured such that one of the plurality of motor drives may be connected to the output of the first motor drive, such that the first motor drive can monitor degradation of an input filter network of any of the plurality of motor drives.

## Patentansprüche

1. Verfahren zum Überwachen einer Degradation mindestens einer Komponente eines Eingangsfilternetzwerks in einem Energiesystem, umfassend eine Motorantriebsschaltung, die dazu konfiguriert ist, AC-Energie von einer Energiequelle (1) bereitzustellen, um einen Motor (7) mit Energie zu versorgen, wobei das Verfahren Folgendes umfasst:
Isolieren der Motorantriebsschaltung von der Energiequelle (1);
Einspeisen eines Testsignals in das Eingangsfilternetzwerk der isolierten Motorantriebsschaltung;
Messen eines ausgebreiteten Signals, das sich aus dem eingespeisten Testsignal ergibt, das sich durch das Filternetzwerk ausbreitet;
Vergleichen des ausgebreiteten Signals mit einem Referenzsignal und, falls sich das ausgebreitete Signal durch ein Vorzeichen und/oder eine Größe von dem Referenzsignal unterscheidet, Identifizieren der Degradation mindestens einer Komponente des Filternetzwerks.

2. Verfahren nach Anspruch 1, ferner umfassend ein derartiges Trennen des Motors (7) von der Motorantriebsschaltung vor dem Einspeisen eines Testsignals in das Eingangsfilternetzwerk (3) der isolierten Motorantriebsschaltung, dass das Testsignal nur durch das Eingangsfilternetzwerk (3) der Motorantriebsschaltung bereitgestellt wird.

3. Verfahren nach einem der vorhergehenden Ansprüche, wobei das Testsignal ein Niederspannungs-Pulsweitenmodulations(PWM)-Signal ist.

4. Verfahren nach einem der vorhergehenden Ansprüche, wobei das Vergleichen des ausgebreiteten Signals mit einem Testsignal ein Vergleichen von Spannungspegeln des ausgebreiteten Signals und des Testsignals in unterschiedlichen Zeitintervallen umfasst.

5. Verfahren nach einem der vorhergehenden Ansprüche, bei einer Installation des Energiesystems ferner umfassend ein Generieren des Testsignals durch
Isolieren der Motorantriebsschaltung von der Energiequelle (1); Einspeisen des Testsignals in das Eingangsfilternetzwerk (3) der isolierten Motorantriebsschaltung;
Messen eines ausgebreiteten Signals, das sich aus dem eingespeisten Testsignal ergibt, das sich durch das Eingangsfilternetzwerk (3) ausbreitet;
Speichern des ausgebreiteten Signals als das Referenzsignal.

6. Verfahren nach einem der vorhergehenden Ansprüche, wobei der Motorantrieb ein erster Motorantrieb einer Vielzahl von Motorantrieben ist und jeder der Vielzahl von Motorantrieben über eine Rekonfigurationsmatrix (13) mit mindestens einem einer Vielzahl von Motoren (14) verbunden ist und wobei die Rekonfigurationsmatrix einen gewünschten Motorantrieb der Vielzahl von Motorantrieben derart mit dem Ausgang des ersten Motorantriebs verbindet, dass die Degradation des Eingangsfilternetzwerks des gewünschten Motorantriebs überwacht werden kann.

7. Motorantrieb zum Durchführen des Verfahrens nach einem der vorhergehenden Ansprüche, wobei der Motorantrieb dazu konfiguriert ist, sich bei Verwendung an seinem Eingang mit einer AC-Energiequelle zu verbinden und an seinem Ausgang einen Motor (7) anzutreiben, wobei der Motorantrieb Folgendes umfasst:
ein Mittel (2) zum Isolieren des Motorantriebs von der AC-Energiequelle;
mindestens ein Eingangsfilternetzwerk (3);
ein Mittel (100) zum Einspeisen eines Testsignals in das Eingangsfilternetzwerk (3) des isolierten Motorantriebs;
ein Mittel (8) zum Messen eines ausgebreiteten Signals, das sich aus dem eingespeisten Testsignal ergibt, das sich durch das Eingangsfilternetzwerk (3) ausbreitet; und
ein Mittel zum derartigen Vergleichen des ausgebreiteten Signals mit einem Referenzsignal, dass, falls sich das ausgebreitete Signal durch ein Vorzeichen und/oder eine Größe von dem Referenzsignal unterscheidet, dann die Degradation mindestens einer Komponente des Eingangsfilternetzwerks (3) identifiziert werden kann.

8. Motorantrieb nach Anspruch 7, wobei der Motorantrieb ferner eine Motorantriebselektronik, umfassend einen Gleichrichter (4), mindestens einen DC-Zwischenkreiskondensator (5) und einen Wechselrichter (6), umfasst und wobei das Mittel (8) zum Messen eines ausgebreiteten Signals eine Motorsteuerung (8) umfasst.

9. Motorantrieb nach Anspruch 8, wobei die Motorantriebselektronik dazu konfiguriert ist, den Motorantrieb von einem an seinem Ausgang verbundenen Motor (7) zu isolieren.

10. Motorantrieb nach einem der Ansprüche 7 bis 9, wobei das Mittel (100) zum Einspeisen eines Testsignals in das Eingangsfilternetzwerk (3) des Motorantriebs einen dedizierten Signalgenerator umfasst.

11. Motorantrieb nach einem der Ansprüche 7 bis 10, ferner umfassend Schutzdioden (10), die dazu konfiguriert sind, zu verhindern, dass während eines normalen Betriebs dem Mittel (100) zum Einspeisen eines Testsignals Energie zugeführt wird.

12. Motorantrieb nach einem der Ansprüche 7 bis 11, wobei das Mittel (100) zum Einspeisen eines Testsignals in das Eingangsfilternetzwerk (3) des Motorantriebs dazu konfiguriert ist, ein Signal, das 28 V oder weniger aufweist, bereitzustellen.

13. System, umfassend
eine Energiequelle (1), die dazu konfiguriert ist, AC-Energie bereitzustellen;
den Motorantrieb nach einem der Ansprüche 9 bis 12 und
einen Motor (7).

14. System, umfassend
eine Vielzahl von Motorantrieben (12), wobei mindestens einer der Motorantriebe ein erster Motorantrieb ist und ein Motorantrieb nach einem der Ansprüche 9 bis 12 ist;
eine Vielzahl von Motoren (14);
wobei jeder der Vielzahl von Motorantrieben über eine Rekonfigurationsmatrix (13) mit mindestens einem der Vielzahl von Motoren (14) verbunden ist.

15. System nach Anspruch 14, wobei die Rekonfigurationsmatrix (13) ferner derart konfiguriert ist, dass einer der Vielzahl von Motorantrieben derart mit dem Ausgang des ersten Motorantriebs verbunden sein kann, dass der erste Motorantrieb die Degradation eines Eingangsfilternetzwerks eines beliebigen der Vielzahl von Motorantrieben überwachen kann.

## Revendications

1. Procédé de surveillance d'une dégradation d'au moins un composant d'un réseau de filtre d'entrée dans un système d'alimentation comprenant un circuit d'entraînement de moteur configuré pour fournir un courant alternatif à partir d'une source d'alimentation (1) afin d'alimenter un moteur (7), le procédé comprenant :
l'isolation du circuit d'entraînement de moteur de la source d'alimentation (1) ;
l'injection d'un signal de test dans le réseau de filtre d'entrée du circuit d'entraînement de moteur isolé ;
la mesure d'un signal propagé résultant du signal de test injecté se propageant à travers le réseau de filtre ;
la comparaison du signal propagé à un signal de référence et, si le signal propagé diffère du signal de référence par signe et/ou amplitude, l'identification d'une dégradation d'au moins un composant du réseau de filtre.

2. Procédé selon la revendication 1, comprenant en outre, avant l'injection d'un signal de test dans le réseau de filtre d'entrée (3) du circuit de commande de moteur isolé, la déconnexion du moteur (7) du circuit de commande de moteur, de sorte que le signal de test soit fourni uniquement par le réseau de filtre d'entrée (3) du circuit de commande de moteur.

3. Procédé selon une quelconque revendication précédente, dans lequel le signal de test est un signal de modulation de largeur d'impulsion, PWM, basse tension.

4. Procédé selon une quelconque revendication précédente, dans lequel la comparaison du signal propagé à un signal de test comprend la comparaison de niveaux de tension du signal propagé et du signal de test à différents intervalles de temps.

5. Procédé selon une quelconque revendication précédente, comprenant en outre la génération du signal de test par, lors de l'installation du système d'alimentation,
l'isolation du circuit d'entraînement de moteur de la source d'alimentation (1) ;
l'injection du signal de test dans le réseau de filtre d'entrée (3) du circuit d'entraînement de moteur isolé ;
la mesure d'un signal propagé résultant du signal de test injecté se propageant à travers le réseau de filtre d'entrée (3) ;
le stockage du signal propagé en tant que signal de référence.

6. Procédé selon une quelconque revendication précédente, dans lequel l'entraînement de moteur est un premier entraînement de moteur parmi une pluralité d'entraînements de moteur, et chacun de la pluralité d'entraînements de moteur est connecté à au moins l'un parmi une pluralité de moteurs (14) via une matrice de reconfiguration (13), et dans lequel la matrice de reconfiguration connecte un entraînement de moteur souhaité de la pluralité d'entraînements de moteur à la sortie du premier entraînement de moteur de sorte que la dégradation du réseau de filtre d'entrée de l'entraînement de moteur souhaité peut être surveillée.

7. Entraînement de moteur pour réaliser le procédé selon une quelconque revendication précédente, l'entraînement de moteur étant configuré pour, en utilisation, se connecter à une source d'alimentation CA au niveau de son entrée et entraîner un moteur (7) au niveau de sa sortie, l'entraînement de moteur comprenant :
un moyen (2) pour isoler l'entraînement de moteur de la source d'alimentation CA ;
au moins un réseau de filtre d'entrée (3) ;
un moyen (100) pour injecter un signal de test dans le réseau de filtre d'entrée (3) de l'entraînement de moteur isolé ;
un moyen (8) pour mesurer un signal propagé résultant du signal de test injecté se propageant à travers le réseau de filtre d'entrée (3) ; et
un moyen pour comparer le signal propagé à un signal de référence de sorte que, si le signal propagé diffère du signal de référence par signe et/ou amplitude, la dégradation d'au moins un composant du réseau de filtre d'entrée (3) peut être identifiée.

8. Entraînement de moteur selon la revendication 7, dans lequel l'entraînement de moteur comprend en outre une électronique d'entraînement de moteur comprenant un redresseur (4), au moins un condensateur de liaison CC (5) et un onduleur (6), et dans lequel le moyen (8) pour mesurer un signal propagé comprend un dispositif de commande de moteur (8).

9. Entraînement de moteur selon la revendication 8, dans lequel l'électronique d'entraînement de moteur est configurée pour isoler l'entraînement de moteur d'un moteur (7) connecté au niveau de sa sortie.

10. Entraînement de moteur selon l'une quelconque des revendications 7 à 9, dans lequel le moyen (100) pour injecter un signal de test dans le réseau de filtre d'entrée (3) de l'entraînement de moteur comprend un générateur de signal dédié.

11. Entraînement de moteur selon l'une quelconque des revendications 7 à 10, comprenant en outre des diodes de protection (10) configurées pour empêcher l'alimentation du moyen (100) pour injecter un signal de test pendant une utilisation normale.

12. Entraînement de moteur selon l'une quelconque des revendications 7 à 11, dans lequel le moyen (100) pour injecter un signal de test dans le réseau de filtre d'entrée (3) de l'entraînement de moteur est configuré pour fournir un signal de 28 V ou moins.

13. Système comprenant
une source d'alimentation (1) configurée pour fournir une alimentation CA ;
le moteur d'entraînement selon l'une quelconque des revendications 9 à 12 et
un moteur (7).

14. Système comprenant
une pluralité d'entraînements de moteur (12), dans lequel au moins l'un des entraînements de moteur est un premier entraînement de moteur, et est un entraînement de moteur selon l'une quelconque des revendications 9 à 12 ;
une pluralité de moteurs (14) ;
dans lequel chacun de la pluralité d'entraînements de moteur est connecté à au moins l'un de la pluralité de moteurs (14) via une matrice de reconfiguration (13).

15. Système selon la revendication 14, dans lequel la matrice de reconfiguration (13) est en outre configurée de sorte que l'un de la pluralité d'entraînements de moteur peut être connecté à la sortie du premier entraînement de moteur, de sorte que le premier entraînement de moteur peut surveiller une dégradation d'un réseau de filtre d'entrée de l'un quelconque de la pluralité d'entraînements de moteur.
